## Europäisches Patentamt
## European Patent Office
## Office européen des brevets

(19)

(11) Veröffentlichungsnummer: **0 144 978**
**B1**

(12) **EUROPÄISCHE PATENTSCHRIFT**

(45) Veröffentlichungstag der Patentschrift:
08.03.89

(51) Int. Cl.⁴: **H 03 K 17/08, H 01 L 27/14**

(21) Anmeldenummer: 84114847.1

(22) Anmeldetag: 06.12.84

(54) Schaltungsanordnung zum Ansteuern eines Thyristors mit einem Fototransistor.

(30) Priorität: 06.12.83 DE 3344435

(43) Veröffentlichungstag der Anmeldung:
19.06.85 Patentblatt 85/25

(45) Bekanntmachung des Hinweises auf die Patenterteilung:
08.03.89 Patentblatt 89/10

(84) Benannte Vertragsstaaten:
CH DE FR GB IT LI

(56) Entgegenhaltungen:
US-A-3 663 838

COMPONENTS REPORT, Band 13, Nr. 4, 1978, Seiten 129-131, MÜNCHEN, (DE). A. HAUENSTEIN: "Low-cost drive of trigger sensitive thyristors"

(73) Patentinhaber: Siemens Aktiengesellschaft Berlin und München, Wittelsbacherplatz 2, D-8000 München 2 (DE)

(72) Erfinder: Tihanyi, Jenö, Dr. Ing., Windeckstrasse 1d, D-8000 München 70 (DE)
Erfinder: Fellinger, Christine, Ing., Germersheimerstrasse 5, D-8000 München 90 (DE)
Erfinder: Leipold, Ludwig, Dipl.- Ing., Strassberger Strasse 125, D-8000 München 40 (DE)

## Beschreibung

Die Erfindung bezieht sich auf eine Schaltungsanordnung zum Ansteuern mindestens eines an einer Wechselspannung liegenden Thyristors mit einem Fototransistor.

Eine solche Schaltungsanordnung ist z. B. aus "Siemens Components", 20 (1982), Heft 3, Seiten 83 ff., insbesondere Bild 2, beschrieben worden. Bei dieser Schaltungsanordnung steuert der Fototransistor den Thyristor über einen Hilfstransistor, wobei die Kollektor-Emitterstrecke des Hilfstransistors der Gate-Kollektorstrekce des Thyristors parallelgeschaltet ist. Die Kollektor-Emitterstrecke des Fototransistors liegt über Wiederstände an einer der Netzspannung proportionalen Wechselspannung. Um ein Einschalten des unbeleuchteten Fotrotransistors bei steilen Spannungsflanken (du/dt-Belastung) zu verhindern, ist der Schaltungsanordnung ausgangsseitig eine RC-Reihenschaltung parallelgeschaltet. Diese dient gleichzeitig zur Kompensation von durch induktive Lasten hervorgerufenen Phasenänderungen. Als Wiederstand wird beispielsweise 100 Ohm und als Kapazität 0,1 µF vorgeschalgen. Dies bedeutet, daß im Ruhezustand, d. h. bei ausgeschaltetem Thyristor, ein Ruhestrom in der Größenordnung einiger mA fließen kann. Außerdem ist eine solche RC-Beschaltung in der angegebenen Dimensionierung zur Integration schlecht geeignet.

Der Erfindung liegt die Aufgabe zugrunde, eine Schaltungsanordnung der genannten Art so weiterzubilden, daß der fließende Ruhestrom wesentlich geringer ist. Außerdem sollen die für den Schutz gegen du/dt-Beanspruchungen vorgesehenen Komponenten leicht in integrierter Form aufgebaut werden können.

Diese Aufgabe wird durch die folgenden Merkmale gelöst:

a) Die Emitter-Kollektorstrecke des Fototransistors ist zwischen einer ersten von zwei Wechselspannungsklemmen und dem Gateanschluß des Thyristors angeschlossen,

b) zwischen dem Basisanschluß des Fototransistors und der zweiten Wechselspannungsklemme ist die Drain-Sourcestrecke eines IGFET vom Anreicherungstyp angeschlossen,

c) zwischen dem Gateanschluß und dem Sourceanschluß des IGFET vom Anreicherungstyp ist die Drain-Sourcestrecke eines IGFET vom Verarmungstyp angeschlossen,

d) der Gateanschluß des IGFET vom Verarmungstyp und sein Sourceanschluß sind elektrisch mit der zweiten Wechselspannungsklemme verbunden,

e) zwischen dem Drainanschluß des IGFET vom Verarmungstyp und der ersten Wechselspannungsklemme ist ein Kondensator angeschlossen.

Weiterbildungen der Erfindung sind Gegenstand der Untersprüche.

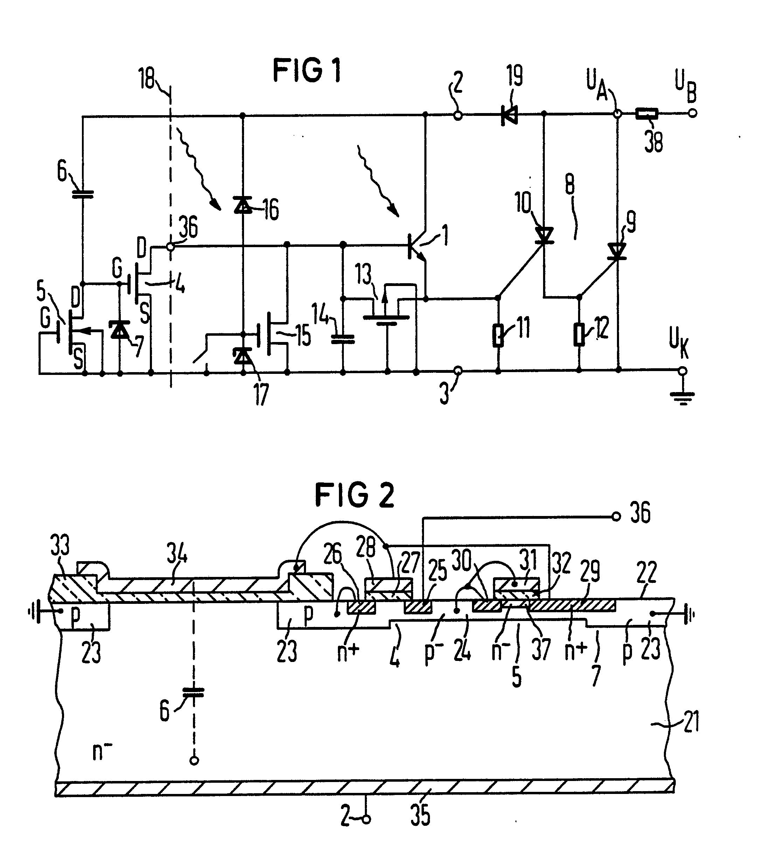

Die Erfindung wird an Hand eines Ausführungsbeispiels in Verbindung mit den Fig. 1 und 2 näher erläutert. Es zeigen:

Fig. 1    die Schaltung eines elektronischen Lastrelais mit dem du/dt-Schutz gemäß der Erfindung und

Fig. 2    die links der gestrichelten Linie 18 in Fig. 1 gezeigten Komponenten des du/dt-Schutzes in integrierter Form.

Die Schaltungsanordnung nach Fig. 1 enthält einen Fototransistor 1. Die Kollektor-Emitterstrecke des Fototransistors 1 liegt zwischen einer ersten Wechselspannungsklemme 2 von zwei Wechselspannungsklemmen 2, 3 und dem Gateanschluß einer Thyristoranordnung 8. Diese Thyristoranordnung kann aus einem einzigen Thyristor, einer Kaskadenschaltung zweier Thyristoren oder einem Thyristor 9 mit integriertem, den Zündstrom verstärkenden Hilfsthyristor 10 bestehen. Zwischen den Gateanschlüssen der Thyristoren 9, 10 und der Wechselspannungsklemme 3 liegen Widerstände 12 bzw. 11, die in bekannter Weise zur Verbesserung der du/dt-Eigenschaften der Thyristoren dienen.

Zwischen dem Basisanschluß des Fototransistors 1 und der Wechselspannungsklemme 3 liegt die Source-Drainstrecke eines IGFET 4 vom Anreicherungstyp. Zwischen den Gateanschluß und den Sourceanschluß dieses IGFET liegt die Source-Drainstrecke eines IGFET 5 vom Verarmungstyp. Der Gateanschluß dieses IGFET ist mit seinem Sourceanschluß verbunden. Die Sourceanschlüsse der IGFET 4, 5 liegen an festem Potential, vorzugsweise an Katodenpotenital $U_K$ des Thyristors 9, d. h. an Masse. Zwischen dem Gateanschluß des IGFET 4 bzw. dem Drainanschluß des IGFET 5 und der Wechselspannungsklemme 2 liegt ein Kondensator 6.

Die Wechselspannungsklemme 2 kann auf dem Potential $U_A$ der Anode des Thyristors 9 liegen. Zweckmäßigerweise wird jedoch zwischen die Anode des Thyristors 9 und die Wechselspannungsklemme 2 eine Diode 19 geschaltet, die nur dann durchlässig ist, wenn am Thyristor Spannung in Durchlaßrichtung anliegt. Damit wird eine Belastung des Fototransistors 1 in Sperrichtung vermieden.

Liegt am Thyristor 9 bzw. an der Thyristoranordnung 8 eine Spannung in Durchlaßrichtung an und wird der Fototransistor 1 belichtet, so fließt ein Transistorstrom durch die Last 38, die Diode 19, den Transistor 1 in den Gateanschluß des Thyristors 10. Dieser zündet und schaltet damit den Thyristor 9 ein. Parallel zum Transistorstrom fließt ein Strom durch den Kondensator 6 und den IGFET 5 zur Wechselspannungsklemme 3. Der IGFET 5 ist vom Verarmungstyp und daher bei der Gate-Sourcespannung 0 V leitend. Mit ansteigender Drain-Source-Spannung wird die Drain-Sourcestrecke des IGFET 5 immer hochohmiger. Durch geeignete Dimensionierung des IGFET 5, die in Verbindung mit Fig. 2 näher ausgeführt wird, wird erreicht, daß der IGFET 5 als Stromgenerator wirkt, d. h. einen praktisch konstanten Strom führt. Damit wird der Kondensator 6 mit konstantem Strom aufgeladen und die Gate-Sourcevorspannung des IGFET 4 steigt an. Dieser ist so dimensioniert, daß seine Einsatzspannung bei normalem Spannungsanstieg nicht erreicht wird. Nähere Erläuterungen zur Dimensionierung sind ebenfalls der Beschreibung zu Fig. 2 zu entnehmen.

Steigt die Spannung an der Wechselspannungsklemme 2 sehr schnell, z. B. mit einer Steilheit von $10^6$ V/µs an, so fließt durch den IGFET 5 aufgrund der oben erwähnten Eigenschaft nach wie vor ein konstanter Strom. Der überwiegende Anteil des Kondensatorstroms kann jetzt zum Gate des IGFET 4 fließen und lädt dessen Source-Gatekapazität auf. Bei Erreichen der Einsatzspannung des IGFET 4 wird dieser leitend und leitet den Basisstrom des Fototransistors 1 ab. Dieser kann damit nicht leitend werden und die Thyristoren bleiben gesperrt. Das Einschalten des IGFET 4 vor dem Fototransistor 1 ist dadurch sichergestellt, daß die Basis-Kollektorkapazität des Fototransistors 1 im allgemeinen wesentlich größer ist als die Gate-Sourcekapazität des IGFET 4. Sollte dies nicht der Fall sein, so kann zwischen Basisanschluß des Fototransistors 1 und die Wechselspannungsklemme 3 ein Kondensator 14 eingeschaltet werden.

Zur Begrenzung der Gate-Sourcespannung des IGFET 4 kann zwischen Gateanschluß und Sourceanschluß eine Zenerdiode 7 angeschlossen werden. Diese begrenzt dann die Gate-Sourcespannung auf eine für das Gateoxid ungefährlichen Wert von beispielsweise 10 V.

Die Schaltungsanordnung nach Fig. 1 kann mit einer Nullpunktsteuerung versehen sein, die sicherstellt, daß im Fototransistor 1 Emitterstrom nur dann fließt, wenn die Spannung an den Wechselspannungsklemmen 2, 3 einen bestimmten Wert nicht überschritten hat. Diese Nullpunktsteuerung ist Gegenstand der europäischen Patentanmeldung EP-A-0 144 977 gleichen Anmeldetags und besteht aus einem IGFET 15 vom Anreicherungstyp, dessen Drain-Sourcestrecke zwischen dem Basisanschluß des Fototransistors 1 und der Wechselspannungsklemme 3 liegt. Der Gateanschluß des IGFET 15 ist über eine Fotodiode 16 mit der Wechselspannungsklemme 2 verbunden. Zwischen dem Gateanschluß des IGFET 15 und der Wechselspannungsklemme 3 kann zum Schutz des Gateoxids des IGFET 15 wieder eine Zenerdiode 17 liegen. Die Fotodiode 16 wird entweder durch die Lichtquelle des Fototransistors 1 oder durch eine mit dieser synchron arbeitende zweite Lichtquelle beleuchtet. Steigt die Wechselspannung an den Klemmen 2, 3 über die erlaubte Spannung an und wird die Fotodiode 16 und der Fototransistor 1 beleuchtet, so fließt ein Strom durch die Fotodiode 16 zum Gateanschluß des IGFET 15 und schaltet diesen ein, bevor der Fototransistor 1 leitend werden kann. Dies hat seine Ursache in der wesentlich kleineren Gate-Sourcekapazität des IGFET 15 verglichen mit der Kollektor-Basiskapazität des Fototransistors 1. Der erwähnte Kondensator 14 verzögert das Einschalten des Fototransistors 1 auch für den beschriebenen Fall der Nullpunktsteuerung.

Zwischen dem Basisanschluß und dem Emitteranschluß des Fototransistors 1 kann die Drain-Sourcestrecke eines weiteren IGFET 13 vom Verarmungstyp angeschlossen sein (Gegenstand der EP-A-0 146 042 vom gleichen Anmeldung). Sein Gateanschluß ist mit der zweiten Wechselspannungsklemme 3 verbunden. Dieser IGFET stellt einen veränderbaren Widerstand dar, der im unbelichteten Zustand des Fototransistors 1 einen geringen Widerstand und im belichteten Zustand des Fototransistors 1 einen hohen Widerstand darstellt. Damit wird einerseits die Sperrspannungsfestigkeit des Fototransistors 1 erhöht und im belichteten Fall die Stromverstärkung nicht beeinträchtigt.

Im integrierten Schaltungsaufbau nach Fig. 2 sind zur Bezeichnung der gleichen Teile wie in Fig. 1 die gleichen Bezugszeichen verwendet. Basis der integrierten Schaltung ist ein Halbleiterkörper 21. In den Halbleiterkörper ist für die IGFET 4, 5 und die Zenerdiode 7 ein Substrat 22 vom entgegengesetzten Leitungstyp planar eingebettet. Dieses Substrat weist stärker dotierte Teile 23 und ein schwächer dotiertes Teil 24 auf. Die genannter Teile können unterschiedliche Dicke haben, können jedoch auch gleich dick sein. In das Substrat ist planar eine Drainzone 25 und eine Sourcezone 26 für den IGFET 4 eingebettet. Auf dem Halbleiterkörper 21 ist eine erste Isolierschicht 27, z. B. aus Siliciumdioxid angeordnet, auf der eine Gateelektrode 28 sitzt. Diese überlappt die Zonen 25, 26 zumindest teilweise. In das gleiche Substrat 22 ist die Sourcezone 29 und die Drainzone 30 für den IGFET 5 planar eingebettet. Zwischen beiden Zonen ist eine Gatezone 37 eingebettet. Die Isolierschicht des IGFET 5 ist mit 32 bezeichnet und überlappt die Sourcezone 29 und die Drainzone 30 mindestens teilweise. Über der Isolierschicht 32 sitzt eine Gateelektrode 31, die elektrisch mit der Sourcezone 30 und dem Substrat verbunden ist. Das Substrat liegt zweckmäßigerweise auf Katodenpotential, bzw. an Massepotential, wodurch kapazitiv erzeugte Ströme abgeleitet werden und keine Störungen der Schaltung hervorrufen.

Die Drainzone 29 des IGFET 5 erstreckt sich bis in einen der stärker dotierten Teile 23 des Substrats 22. Da die Drainzone 29 stark dotiert ist, bricht der zwischen der Drainzone 29 und dem stark dotierten Teil 23 des Substrats 22 gelegene pn-Übergang bei geringen Spannungen, z. B. bei 10 V, durch. Dies entspricht der Funktion der Zenerdiode 7 und begrenzt das Gatepotential für den IGFET 4 auf einen für seine Isolierschicht 27 ungefährlichen Wert.

Der Kondensator 6 weist eine Elektrode 34 auf, die beispielsweise aus stark n-dotiertem polykristallinem Silicium besteht. Die Elektrode 34 ist auf einer auf der Oberfläche des Halbleiterkörpers 21 liegenden Isolierschicht 33 angeordnet. Diese kann ebenfalls aus Siliciumdioxid bestehen. Unter dem Rand der Kondensatorelektrode 34 liegt eine Zone mit einem Leitungstyp, der dem des Halbleiterkörpers 21 entgegengesetzt ist. Diese Zone kann vorzugsweise durch einen der relativ stark dotierten Teile 23 des Substrats 22 gebildet sein. Die Kondensatorelektrode kann am Rand über der Zone 23 eine Abstufung aufweisen, die auf einem entsprechend dickeren Teil der Isolierschicht 33 liegt. Der Teil 23 hat alleine oder in Verbindung mit der Abstufung der Kondensatorelektrode 34 den Zweck, ein Abfließen von Ladungsträgern aus dem Kondensator zu verhindern. Die Zonen der integrierten Schaltung nach Fig. 2 können die eingezeichneten Leitungstypen und die eingezeichnete grobe Unterteilung der Dotierungskonzentrationen aufweisen. Alle Zonen können jedoch auch die inversen Leitfähigkeitstypen haben. Die Dotierung und Abmessungen der einzelnen Komponenten können folgende Größen haben:

Spezifischer Widerstand des Halbleiterkörpers gleich 30 bis 50 Ohm cm; Dicke: 200 bis 300 $\mu$m;

Dotierung der stark p-dotierten Zonen gleich $10^{17}$ bis $10^{18}$ Atome cm$^{-3}$;

Dotierung der schwach p-dotierten Teile gleich $10^{16}$ Atome cm$^{-3}$;

Dotierung der Gatezone 37 durch Arsenimplantation von z. B. $1 \cdot 10^{12}$ Atome cm$^{-2}$;

Abstand der Drainzonen von den Sourcezonen: 5 bis 200 $\mu$m;

Dicke der Oxidschichten 32 und 27 gleich 70 nm;

Dicke des dickeren Teils der Isolierschicht 33: 1,5 $\mu$m;

Tiefe der stark p-dotierten Zonen: 1 bis 4 $\mu$m:

Dicke der stark n-dotierten Zonen: 0,15 bis 2 $\mu$m;

Abmessung der Kondensatorelektrode 34: 100 mal 100 $\mu$m.

Damit ergibt sich für den Kondensator (abhängig von der Spannung $U_B - U_K$) eine Größe von etwa 6 bis 2 pF. Die Einsatzspannungen der IGFET 4 und 5 können auf bekannte Weise durch die Dicke der Isolierschichten 27, 32 und durch den spezifischen Widerstand der Gatezonen bestimmt werden. Der spezifische Widerstand der Gatezone für den IGFET 4 kann, wie dargestellt, auch dadurch eingestellt werden, daß er teilweise den stärker dotierten Teil 23 und teilweise den schwächer dotierten Teil 24 des Substrats 22 umfaßt. Mit den angegebenen Dotierurgen und Abmessungen liegen die Einsatzspannungen der IGFET 4 und 5 zwischen 4 und 10 V.

Die Betriebsspannung wird dem Halbleiterkörper über eine Elektrode 35 zugeführt. Zur Verbindung der rechts der gestrichelten Linie 18 (Fig. 1) liegenden Teile mit der Anordnung nach Fig. 2 ist eine Klemme 36 vorgesehen.

**Patentansprüche**

1. Schaltungsanordnung zum Ansteuern mindestens eines an einer Wechselspannung liegenden Thyristors mit einem Fototransistor, gekennzeichnet durch die Merkmale:
   a) Die Emitter-Kollektorstrecke des Fototransistors ist zwischen einer ersten von zwei Wechselspannungsklemmen (2, 3) und dem Gateanschluß des Thyristors angeschlossen,
   b) zwischen dem Basisanschluß des Fototransistors 1 und der zweiten Wechselspannungsklemme (3) ist die Drain-Sourcestrecke eines als Stromgenerator wirkenden IGFET (4) vom Anreicherungstyp angeschlossen,
   c) zwischen dem Gateanschluß und dem Sourceanschluß des IGFET (4) vom Anreicherungstyp ist die Drain-Sourcestrecke einer IGFET (5) vom Verarmungstyp angeschlosssen,
   d) der Gateanschluß des IGFET (5) vom Verarmungstyp und sein Sourceanschluß sind elektrisch mit der zweiten Wechselspannungsklemme (5) verbunden,
   e) zwischen dem Drainanschluß des IGFET (%) vom Verarmungstyp und der ersten Wechselspannungsklemme (2) ist ein Kondensator (6) angeschlossen.

2. Schaltungsanordnung nach Anpruch 1, dadurch gekennzeichnet, daß die zweite Wechselspannungsklemme (3) elektrisch mit dem Katodenanschluß des Thyristors verbunden ist.

3. Schaltungsanrodnung nach Anspruch 1 oder 2, dadurch gekennzeichnet, daß zwischen Gateanschluß des IGFET (4) vom Anreicherungstyp und seinem Sourceanschluß eine Zenerdiode (7) angeschlossen ist.

4. Schaltungsanordnung nach einem der Ansprüche 1 bis 3, dadurch gekennzeichnet, daß zwischen dem Anodenanschluß des Thyristors und der ersten Wechselspannungsklemme (2) eine Diode (19) liegt, die derart gepolt ist, daß sie gesperrt ist, wenn am Thyristor Spannung in Sperrichtung anliegt.

5. Schaltungsanordnung nach einem der Ansprüche 1 bis 3, gekennzeichnet durch die Merkmale:
   a) In einen Halbleiterkörper (21) vom ersten Leitungstyp ist ein Substrat (22) vom zweiten Leitungstyp planar eingebettet,
   b) In das Substrat (22) ist die Sourcezone (30) und die Drainzone (29) des IGFET (4) vom Anreicherungstyp eingebettet,

c) in das gleiche Substrat (22) ist die Sourcezone (25) und die Drainzone (26) des IGFET (5) vom Verarmungstyp eingebettet,

d) zwischen Sourcezone und Drainzone des IGFET vom Verarmungstyp (5) ist eine Gatezone (37) eingebettet, die vom gleichen Leitungstyp wie diese Zonen ist, aber schwächere Dotierung aufweist,

e) die Drain- und Sourcezone jedes IGFET ist von einer auf einer Isolierschicht (32, 27) angeordneten Gateelektrode (31, 28) zumindest überlappt,

f) auf dem Halbleiterkörper ist außerhalb des Substrats (22) eine weitere Isolierschicht (33) angeordnet, auf der eine Elektrode (34) des Kondensators (6) sitzt.

6. Schaltungsanordnung nach Anspruch 5, dadurch gekennzeichnet, daß unter dem Rand der Kondensatorelektrode (34) eine Zone vom zweiten Leitungstyp in den Halbleiterkörper (21) planar eingebettet ist.

7. Schaltungsanordnung nach Anspruch 6, dadurch gekennzeichnet, daß die genannte Zone durch einen stärker dotierten Teil (23) des Substrats (22) gebildet ist.

8. Schaltungsanordnung nach Anspruch 3 und 5, dadurch gekennzeichnet, daß das Substrat stärker und schwächer dotierte Teile (23 bzw. 24) hat, daß sich die Drainzone (29) des IGFET (5) vom Verarmungstyp bis in einen höher dotierten Teil (23) des Substrats (22) erstreckt und daß das Substrat (22) elektrisch mit der zweiten Wechselspannungsklemme (3) verbunden ist.

9. Schaltungsanordnung nach einem der Ansprüche 1 bis 4, dadurch gekennzeichnet, daß der IGFET vom Anreicherungstyp (4) eine Einsatzspannung hat, die höher ist als die Schwellspannung des Fototransistors (1).

## Claims

1. Circuit arrangement for controlling at least one thyristor, which is connected to an alternating voltage, having a phototransistor, characterized by the following features:

a) the emitter/collector path of the phototransistor is connected between a first one of two alternating- voltage terminals (2, 3) and the gate connection of the thyristor,

b) the drain/source path of an IGFET (4) of the enrichment type, acting as a current generator, is connected between the base connection of the phototransistor 1 and the second alternating-voltage terminal (3),

c) the drain/source path of an IGFET (5) of the depletion type is connected between the gate connection and the source connection of the IGFET (4) of the enrichment type,

d) the gate connection of the IGFET (5) of the depletion type and its source connection are electrically connected to the second alternating-voltage terminal (3),

e) a capacitor (6) is connected between the drain connection of the IGFET (5) of the depletion type and the first alternating-voltage terminal (2).

2. Circuit arrangement according to Claim 1, characterized in that the second alternating-voltage terminal (3) is electrically connected to the cathode connection of the thyristor.

3. Circuit arrangement according to Claim 1 or 2, characterized in that a Zener diode (7) is connected between the gate connection of the IGFET (4) of the enrichment type and its source connection.

4. Circuit arrangement according to one of Claims 1 to 3, characterized in that a diode (19), which is polarized in such a manner that it is cut off if voltage is present in the reverse direction at the thyristor, is connected between the anode connection of the thyristor and the first alternating-voltage terminal (2).

5. Circuit arrangement according to one of Claims 1 to 3, characterized by the following features:

a) in a semiconductor body (21) of the first type of conduction, a substrate (22) of the second type of conduction is embedded in a planar manner,

b) the source zone (30) and the drain zone (29) of the IGFET (4) of the enrichment type is embedded in the substrate (22),

c) the source zone (25) and the drain zone (26) of the IGFET (5) of the depletion type is embedded in the same substrate (22),

d) between the source zone and drain zone of the IGFET of the depletion type (5), a gate zone (37) is embedded which is of the same type of conduction as these zones but exhibits weaker doping,

e) the drain and source zone of each IGFET is at least overlapped by a gate electrode (31, 28) arranged on an insulating layer (32, 27),

f) a further insulating layer (33), on which one electrode (34) of the capacitor (6) is located, is arranged outside the substrate (22) on the semiconductor body.

6. Circuit arrangement according to Claim 5, characterized in that a zone of the second type of conduction is embedded in a planar manner in the semiconductor body (21) below the edge of the capacitor electrode (34).

7. Circuit arrangement according to Claim 6, characterized in that the said zone is formed by a part (3) of the substrate (22) with stronger doping.

8. Circuit arrangement according to Claim 3 and 5, characterized in that the substrate has parts (23 and 24, respectively) of stronger and weaker doping, that the drain zone (29) of the IGFET (5) of the depletion type extends into a part (23) of the substrate (22) with higher doping and that the substrate (22) is electrically connected to the second alternating voltage terminal (3).

9. Circuit arrangement according to one of Claims 1 to 4, characterized in that the IGFET of the enrichment type (4) has an operating voltage which is higher than the threshold voltage of the phototransistor (1).

**Revendications**

1. Montage pour commander au moins un thyristor raccordé à une tension alternative et comportant un phototransistor, remarquable par les caractéristiques suivantes:
   a) la voie émetteur-collecteur du phototransistor est branchée entre une première de deux bornes de tension alternative (2, 3) et la borne de grille du thyristor,
   b) la voie drain-source d'un transistor IGFET (4) du type à enrichissement, agissant en tant que générateur de courant, est branchée entre la borne de base du phototransistor (1) et la seconde borne (3) de la tension alternative,
   c) la voie drain-source d'un transistor IGFET (5) du type à appauvrissement est branchée entre la borne de grille et la borne de source du transistor IGFET (4),
   d) la borne de grille du transistor IGFET (5) du type à appauvrissement et sa borne de source sont reliées électriquement à la seconde borne (3) de la tension alternative,
   e) un condensateur (6) est branché entre la borne de drain du transistor IGFET (5) du type à appauvrissement et la première borne (2) de la tension alternative.

2. Montage suivant la revendication 1, caractérisé par le fait que la seconde borne (3) de la tension alternative est reliée électriquement à la borne de cathode du thyristor.

3. Montage suivant la revendication 1 ou 2, caractérisé par le fait qu'une diode Zener (7) est branchée entre la borne de grille du transistor IGFET (4) du type à enrichissement et sa borne de source.

4. Montage suivant l'une des revendications 1 à 3, caractérisé par le fait qu'entre la borne d'anode du thyristor et la première borne (2) de la tension alternative se trouve branchée une diode (19) qui est polarisée de telle sorte qu'elle est bloquée lorsqu'une tension est appliquée au thyristor dans le sens de blocage.

5. Montage suivant l'une des revendications 1 à 3, remarquable par les caractéristiques suivantes:
   a) un substrat (22) possédant le second type de conductivité est inséré selon le mode planar dans le corps semiconducteur (21) possédant le premier type de conductivité,
   b) la zone de source (30) et la zone de drain (29) du transistor IGFET (4) du type à enrichissement sont insérées dans le substrat (22),
   c) la zone de source (25) et la zone de drain (26) du transistor IGFET (5) du type à appauvrissement sont insérées dans le même substrat (22),
   d) entre la zone de source et la zone de drain du transistor IGFET du type à appauvrissement (5) se trouve insérée une zone de grille (37) qui possède le même type de conductivité de ces zones, mais possède un dopage plus faible,
   e) une électrode de grille (31, 28) disposée sur une couche isolante (32, 27) est au moins en chevauchement sur la zone de drain et la zone de source de chaque transistor IGFET,
   e) sur le corps semiconducteur se trouve disposée, en dehors du substrat (22), une autre couche isolante (33), sur laquelle est placée l'électrode (34) du condensateur (6).

6. Montage suivant la revendication 5, caractérisé par le fait qu'une zone possédant le second type de conductivité est insérée selon le mode planar dans le corps semiconducteur (21) au-dessous du bord de l'électrode (34) du condensateur.

7. Montage suivant la revendication 6, caractérisé par le fait que ladite zone est formée par une partie plus fortement dopée (23) du substrat (22).

8. Montage suivant la revendication 3 et 5, caractérisé par le fait que le substrat possède des zones (23 et 24) dopées plus fortement et plus faiblement, que la zone de drain (29) du transistor FET (5) du type à appauvrissement s'étend jusque dans une partie (23), possédant un dopage plus intense, du substrat (22) et que le substrat (22) est relié électriquement à la seconde borne (3) de la tension alternative.

9. Montage suivant l'une des revendications 1 à 4, caractérisé par le fait que le transistor IGFET du type à enrichissement possède une tension de déclenchement supérieure à la tension de seuil du transistor (1).

## FIG 1

## FIG 2

1